# EUROPÄISCHE PATENTANMELDUNG

(11) **EP 0 786 335 A1**
(43) Veröffentlichungstag der Anmeldung: **30.07.1997**
(21) Anmeldenummer: 96117310.1
(22) Anmeldetag: 29.10.1996
(51) Int. Cl.: B32B 31/08, B30B 5/06, B29C 43/48

(54) **Verfahren und Vorrichtung zur Herstellung von harzimprägnierten Schichtpressstoffen**

(30) Priorität: 07.11.1995 DE 19541406
(71) Anmelder: Held, Kurt, 78636 Trossingen (DE)
(72) Erfinder: Held, Kurt, 78636 Trossingen (DE)

(57) **Zusammenfassung**

Bei einem Verfahren zur Herstellung von harzimprägnierten, mit wenigstens einer Deckfolie versehenen Schichtpreßstoffen, bei denen mehrere Einzelbahnen (7') und die Deckfolie (5') unter Wärmeeinwirkung und Ausübung von Flächendruck zu einem Materialpaket verpreßt werden, werden die Einzelbahnen (7') zusammen mit der Deckfolie (5') solange der Wärmeeinwirkung und dem Flächendruck ausgesetzt, bis das Harz ausgehärtet ist. Das Verfahren ist dadurch gekennzeichnet, daß harzfreie Einzelbahnen (7') verwendet werden, auf welche vor der Verpressung ein lösemittelarmes Harz aufgebracht wird. Die mit dem Harz versehenen Einzelbahnen (7') werden zusammen mit der Deckfolie (5') der Verpressung zugeführt.

Zur Durchführung des Verfahrens ist eine Doppelbandpresse vorgesehen, mit einer Reaktionszone (2), in der die Einzelbahnen (7') und die Deckfolien miteinander verpreßt werden. Die Reaktionszone (2) hat seitliche Abdichtungen (5'). Die Doppelbandpresse weist eine Vorrichtung (8) zum Aufbringen des Harzes auf die Einzelbahnen (7') auf.

## Beschreibung

Die Erfindung betrifft ein Verfahren und eine Vorrichtung zur Herstellung von harzimprägnierten, mit wenigstens einer Deckfolie versehenen Schichtpreßstoffen, bei denen mehrere Einzelbahnen und die Deckfolie unter Wärmeeinwirkung und Ausübung von Flächendruck zu einem Materialpaket verpreßt werden, wobei die Einzelbahnen zusammen mit der Deckfolie solange der Wärmeeinwirkung und dem Flächendruck ausgesetzt werden, bis das Harz ausgehärtet ist.

Die Herstellung von harzimprägnierten, mit einer Deckfolie versehenen Schichtpreßstoffen, insbesondere die Herstellung von kupferkaschierten Elektrolaminaten, erfolgte üblicherweise auf diskontinuierlich arbeitenden Etagenpressen. Da insbesondere bei Elektrolaminaten die Qualität eine besondere Rolle spielt, muß bei der Herstellung dieser Schichtpreßstoffe besondere Sorgfalt angewandt werden. Zur Steigerung der Produktion und zur Erhöhung der Qualität der Schichtpreßstoffe ist man dazu übergegangen, die Schichtpreßstoffe auf Doppelbandpressen herzustellen.

So ist aus der EP 0 120 192 A2, von der die vorliegende Erfindung ausgeht, ein Verfahren zur Herstellung von harzimprägnierten, mit zwei Kupferfolien beschichteten Schichtpreßstoffen bekannt, bei welchem mehrere harzimprägnierte Einzelbahnen und die Kupferfolien in einer Doppelbandpresse zu einem Materialpaket verpreßt werden. Geschichtete, beharzte Bahnen für den Schichtstoffkern werden von Vorratsrollen abgewickelt und mit den Kupferfolien, die zuvor auf Verfahrenstemperatur gebracht werden, mit gleicher Geschwindigkeit mit der Ober- und Unterseite des Schichtstoffkerns zusammengeführt. Die Aushärtung des Schichtstoffkerns und Verklebung desselben mit den Kupferfolien erfolgt in der Reaktionszone der Doppelbandpresse durch Wärme und Druck.

Die bei dem bekannten Verfahren verwendeten harzimprägnierten Einzelbahnen werden in einem separaten Prozeß hergestellt. Ein Verfahren zur Herstellung von harzimprägnierten Materialbahnen ist aus der DE 38 34 993 A1 bekannt. Bei dem bekannten Verfahren werden unbeharzte Materialbahnen von einer Rolle abgewickelt und auf das von der Auslaufzone in die Einlaufzone einer Doppelbandpresse rücklaufende Bandtrum eines Preßbandes aufgelegt. Zuvor oder danach wird die Materialbahn mit einem lösungsmittelarmen Harz versehen. Das rücklaufende Bandtrum ist beheizt, so daß auf die mit Harz versehene Materialbahn Wärme einwirkt und die Imprägnier- und Trocknungsprozesse für die Materialbahn auf dem rücklaufenden Bandtrum stattfinden. Die Geschwindigkeit und die Temperatur des rücklaufenden Bandtrums sind so bemessen, daß die Materialbahn bis zum sogenannten B-Zustand aushärtet. Bei dem B-Zustand handelt es sich um eine Reaktion des Harzes, die in einem stabilen, jedoch noch schmelzbaren Zustand für das Harz führt. Die Herstellung der harzimprägnierten Materialbahn, die auch als Prepreg bezeichnet wird, ist danach abgeschlossen.

Des weiteren ist aus der DE 41 29 190 A1 ein Verfahren zur kontinuierlichen Herstellung von harzimprägnierten Materialbahnen bekannt, bei dem lösungsmittelarmes Harz auf die Materialbahn aufgestreut wird. Die mit dem aufgestreuten Harz versehene Materialbahn wird anschließend in einer Doppelbandpresse der Einwirkung von Temperatur und Flächendruck ausgesetzt. Temperatur und Flächendruck sind so bemessen, daß die Materialbahn bis zum B-Zustand aushärtet.

Ausgehend von dem bekannten Stand der Technik liegt der Erfindung die Aufgabe zugrunde, ein Verfahren beziehungsweise eine Vorrichtung der eingangs genannten Art anzugeben, mittels dem beziehungsweise mittels der die Herstellung von harzimprägnierten, mit wenigstens einer Deckfolie versehenen Schichtpreßstoffen vereinfacht wird.

Die Lösung dieser Aufgabe ergibt sich aus den Merkmalen des kennzeichnenden Teils des Anspruchs 1 beziehungsweise 5. Vorteilhafte Weiterbildungen der Erfindung ergeben sich aus den Unteransprüchen.

Gemäß der Erfindung werden zur Herstellung der Schichtpreßstoffe harzfreie Einzelbahnen verwendet, auf welche vor der Verpressung ein lösemittelarmes oder lösemittelfreies Harz aufgebracht wird, und werden die mit dem Harz versehenen Einzelbahnen zusammen mit der Deckfolie der Verpressung zugeführt. Durch eine derartige Vorgehensweise wird die Herstellung von harzimprägnierten, mit einer Deckfolie versehenen Schichtpreßstoffen in einem Schritt durchgeführt. Statt zunächst eine harzimprägnierte Materialbahn herzustellen und die harzimprägnierte Materialbahn in einem zweiten Schritt mit einer Deckfolie zu versehen, wird das Einbringen von Harz und das Aufbringen der Deckfolie in einem Schritt vollzogen. Da beim herkömmlichen Verfahren die harzimprägnierte Materialbahn abgekühlt und beim Aufbringen der Deckfolie wieder erwärmt werden muß, ergibt sich beim erfindungsgemäßen Verfahren eine beachtliche Energieeinsparung.

Die Energieeinsparung beim erfindungsgemäßen Verfahren wird durch die Verwendung eines lösemittelarmen beziehungsweise lösemittelfreien Harzes noch vergrößert, da zur Verdampfung von Lösemittel keine Energie aufgewendet werden muß. In vorteilhafter Weise wird das Harz in Pulverform auf die Einzelbahnen aufgebracht. Es kann jedoch auch als Schmelze auf die Einzelbahnen aufgebracht werden, wenn dies zweckmäßig ist. Es ist jedoch Voraussetzung, daß das Harzsystem während der Verpressung schmilzt, und daß die Schmelze das Verstärkungsmaterial benetzt. Geringe Restgehalte an Lösemittel, wie beispielsweise Wasser, können die Fließfähigkeit der Schmelze erhöhen und können deshalb zugelassen werden. Voraussetzung ist jedoch, daß sie im Endprodukt nicht stören.

Besonders gute Ergebnisse können dadurch erreicht werden, daß das Harz nur zwischen die mittleren Einzelbahnen verbracht wird. Nachdem die Einzelbahnen zusammen mit der Deckfolie der Wärmeeinwirkung und dem Flächendruck ausgesetzt werden, und das Materalpaket von außen erwärmt wird, schmilzt das Harz erst, wenn die Deckfolie und die harzfreien äußeren Einzelbahnen schon heiß sind. Dies wirkt sich auf das Imprägnierergebnis sehr günstig aus, da das heiße Gewebe das Fließen der Harzschmelze fördert.

In dem so hergestellten, fertigen Laminat befindet sich der größere Teil des Harzes in der Mitte des Laminats und die biegungsversteifenden Verstärkungsgewebe befinden sich nahe den Oberflächen. So erreicht man bei gleichem Einsatz und Verstärkungsgeweben besonders hohe Biegesteifigkeiten.

In vorteilhafter Weise kann der Schichtpreßstoff unter Druckeinwirkung abgekühlt werden. Hierdurch wird die Qualität des Schichtpreßstoffes noch erhöht.

In vorteilhafter Weise ist zur Durchführung des erfindungsgemäßen Verfahrens eine Doppelbandpresse vorgesehen, mit einer Reaktionszone, in der die Einzelbahnen verpreßt werden, wobei die Reaktionszone seitliche Abdichtungen hat. Die Doppelbandpresse weist ferner eine Vorrichtung zum Aufbringen des Harzes auf die Einzelbahnen auf. In vorteilhafter Weise kann vor der Aufbringvorrichtung eine Mühle vorgesehen sein, in der grobkörniges Harz zu Pulver gemahlen wird.

Durch die seitlichen Abdichtungen wird zusammen mit dem in fester Form vorliegenden Harz in der Einlaufzone der Doppelbandpresse eine Reaktionszone erreicht, in der sehr hohe Drücke ausgeübt werden können. Die Reaktionszone ist an der Auslaufseite der Doppelbandpresse durch den fertigen Schichtpreßstoff, an den Seiten durch die seitlichen Abdichtungen und an der Einlaufseite der Doppelbandpresse durch das in fester Form beziehungsweise als Schmelze vorliegende Harz abgedichtet, so daß sich eine als geschlossene Kammer ausgebildete Reaktionszone ergibt.

In einer isobaren Doppelbandpresse, die sich für die Herstellung spannungsarmer Laminate besonders gut eignet, ändert sich die Massenverteilung des Materials durch den Preßvorgang nicht. Um so wichtiger ist es, das Harz über die Breite der Presse so zu dosieren, wie es später im Laminat gewünscht ist. Daher ist in vorteilhafter Weise eine Vorrichtung zum Verteilen des Harzes auf die Einzelbahnen vorgesehen. Besonders günstig ist es, wenn die Vorrichtung derart ausgesbildet ist, daß das Harz gleichmäßig auf die Einzelbahnen verteilt wird.

Wenngleich auch vorgesehen ist, daß ein lösemittelarmes beziehungsweise lösemittelfreies, festes Harz verwendet wird, läßt sich das erfindungsgemäße Verfahren auch mit einer hochviskosen Lösung durchführen. Die Herstellung einer hochviskosen Lösung ist sehr viel billiger als die Herstellung von Pulver. Dies liegt daran, daß die Herstellung zum Beispiel einer Phenolharzlösung immer ein Zwischenschritt zur Herstellung von lösemittelarmen beziehungsweise -freien Phenolharzen ist. Das Verdampfen des Lösungsmittels ist also ein unausweichlicher Verfahrensschritt.

Zur Herstellung von Dekorlaminat sollte der Lösemittelgehalt der Lösung so niedrig wie möglich sein. Er muß jedoch zumindest so hoch sein, daß die Lösung noch gepumpt werden kann. Die Dosierung erfolgt zweckmäßigerweise durch eine Breitschlitzdüse auf das rücklaufende Band im Bereich der Auslauftrommel. Das rücklaufende Bandtrum wird genutzt, um darauf das Lösemittel zu verdampfen, so daß das Band im Bereich der Einlauftrommel mit getrocknetem, festem oder schmelzflüssigem Harz bedeckt ankommt.

Diese Trocknung ist aus mehreren Gründen weitaus weniger energieaufwendig, als die herkömmliche Trocknung eines mit gelöstem Harz getränkten Papiers. Zum einen muß nur ungefähr die halbe Menge Lösemittel pro Kilogramm Festharz verdampft werden, zum andern muß im Vergleich zur Umlufttrocknung nur wenig Luft zusätzlich zum Harz erwärmt werden. Beim Aufbringen von Dekorlaminaten hat diese Auftragsform den zusätzlichen Vorteil, daß die beiden Seiten des Laminats von verschiedenen Kunststoffen gebildet werden können.

Durch die Anwendung des erfindungsgemäßen Verfahrens können etwa 1,6 Kilogramm Lösemittel pro Quadratmeter Laminat eingespart werden. Der Aufwand zur Reinhaltung der Umgebungsluft verringert sich daher erheblich. Statt der Durchführung von zwei Teilprozessen, der Herstellung von Prepreg für den Laminatkern und dem Aufbringen der Deckfolie, wird das Laminat in einem Verfahrensschritt hergestellt. Des weiteren verbessert sich durch die Verwendung des erfindungsgemäßen Verfahrens die Laminatqualität. Durch die Verwendung der Dichtungsdrähte erhält man einen sauberen Rand, wodurch der Ausschuß verringert wird.

Des weiteren kann der Aufwand bei der Steuerung der Bahnkanten verringert werden, da harzfreie Einzelbahnen genauer aufgewickelt werden können als Prepreg-Bahnen. Durch die Anwendung des erfindungsgemäßen Verfahrens erhält man eine Konzentration der Verstärkungsmaterialien nahe der Deckfolie. Daraus resultiert eine höhrere Steifigkeit bei gleichem Glasgehalt.

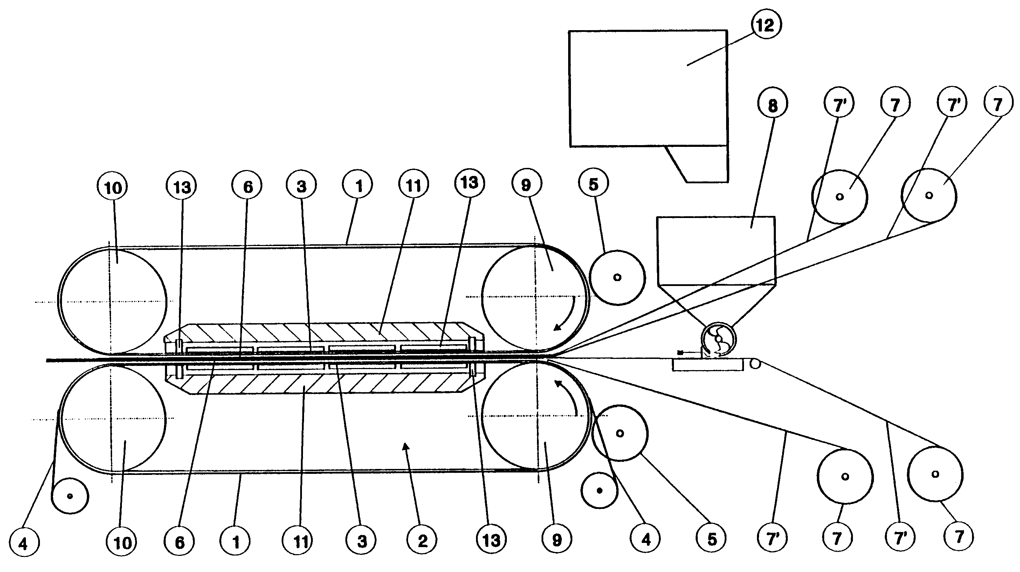

Weitere Einzelheiten, Merkmale und Vorteile der vorliegenden Erfindung ergeben sich aus der nachfolgenden Beschreibung eines besonderen Ausführungsbeispiels unter Bezugnahme auf die Zeichnung.

Es zeigt die einzige Figur die schematische Anordnung einer erfindungsgemäß ausgebildeten Doppelbandpresse in seitlicher Darstellung.

Zwei endlose Preßbänder 1 werden jeweils über eine einlaufseitige Umlenktrommel 9 und eine auslaufseitige Umlenktrommel 10 geführt. Die beiden Preßbänder sind so angeordnet, daß sie sich teilweise mit ihren Oberflächen gegenüberstehen. Im Bereich der sich gegenüberstehenden Preßbänder 1 befindet sich eine Reaktionszone 2, welche aus Druckplatten 11 und Heizplatten 3 gebildet wird. Mittels der Druckplatten 11 wird mit Hilfe von Dichtungen auf herkömmliche Weise eine Druckkammer gebildet. Mittels der Druckkammer wird auf die Innenseiten der Preßbänder 1 ein Druck ausgeübt. Die in der Druckkammer angeordneten Heizplatten 3 übertragen ihre Wärme innerhalb der Reaktionszone 2 auf die Preßbänder 1.

Am einlaufseitigen Ende der Doppelbandpresse werden auf beiden Seiten der beiden Preßbänder 1 Dichtdrähte 4 in die Doppelbandpresse eingeführt, welche in entsprechenden Ausnehmungen der Preßbänder 1 mit den Preßbändern laufen. Durch die Dichtungsdrähte 4 wird eine seitliche Abdichtung der Reaktionszone 2 erreicht. Eine derartige Abdichtung der Reaktionszone 2 ist beispielsweise aus der DE 43 01 844 A1 bekannt.

Am auslaufseitigen Ende der Reaktionszone 2 sind Kühlplatten 6 angeordnet.

Am einlaufseitigen Ende der Doppelbandpresse sind Vorratsrollen 7 angeordnet, von denen harzfreie Einzelbahnen 7' abgewickelt werden. Des weiteren sind am einlaufseitigen Ende der Doppelbandpresse zusätzliche Vorratsrollen 5 angeordnet, von denen eine Kupferfolie 5' abgewickelt wird. Die harzfreien Einzelbahnen 7' und die Kupferfolien 5' werden zusammen in die Doppelbandpresse geleitet.

Im Bereich der Einlaufseite der Doppelbandpresse ist eine Streuvorrichtung 8 angeordnet, mittels der lösemittelarmes Harz auf eine der mittleren Einzelbahnen gestreut wird. Die Streuvorrichtung 8 ist so ausgebildet, daß das Harz dosiert und auf die Einzelbahnen gleichmäßig verteilt werden kann.

Oberhalb der Streuvorrichtung 8 ist eine Vorrichtung 12 zum Mahlen von grobkörnigem Harz zu Pulver vorgesehen. Das gemahlene Harz wird in der Vorrichtung 12 in die Streuvorrichtung 8 geleitet.

Zusammen mit den Kupferfolien 5' werden die mit Harz versehenen Glasgewebe-Einzelbahnen 7' in die Presse eingezogen. Das Paket wird von außen beheizt und komprimiert. Dadurch entweicht zuerst der größte Teil der im Gewebe vorhandenen Luft, dann schmilzt das Harz wegen des steilen Temperaturanstiegs zu einer sehr dünnflüssigen Schmelze. Die Viskosität dieser Schmelze erniedrigt sich weiter, wenn sie in das heiße Glasgewebe eindringt. So gelingt in einem Schritt eine gute, weitgehend porenfreie Imprägnierung mehrerer Lagen Glasgewebe ohne Verwendung von Lösemitteln.

Im Anschluß an die Imprägnierung werden Druck und Temperatur beibehalten, wodurch das Harz weiter aushärtet. Die Unterbrechung des Härtevorgangs, wie sie für alle Verfahren zur Herstellung von Elektrolaminat aus Prepreg typisch war, unterbleibt also. Die Temperatur wird im weiteren Verlauf der Reaktionszone erhöht, um die Härtezeit des Harzes zu verkürzen. Der Druck wird aufrechterhalten, um eventuelle niedermolekulare Verunreinigungen, einschließlich Luft, in der Harzschmelze gelöst zu halten.

## Patentansprüche

1. Verfahren zur Herstellung von harzimprägnierten, mit wenigstens einer Deckfolie versehenen Schichtpreßstoffen, bei denen mehrere Einzelbahnen (7') und die Deckfolie (5') unter Wärmeeinwirkung und Ausübung von Flächendruck zu einem Materialpaket verpreßt werden, wobei die Einzelbahnen (7') zusammen mit der Deckfolie (5') solange der Wärmeeinwirkung und dem Flächendruck ausgesetzt werden, bis das Harz ausgehärtet ist,
dadurch gekennzeichnet,
daß harzfreie Einzelbahnen (7') verwendet werden, auf welche vor der Verpressung ein lösemittelarmes Harz aufgebracht wird, und die mit dem Harz versehenen Einzelbahnen (7') zusammen mit der Deckfolie (5') der Verpressung zugeführt werden.

2. Verfahren nach Anspruch 1,
dadurch gekennzeichnet,
daß das Harz in Pulverform auf die Einzelbahnen (7') aufgebracht wird.

3. Verfahren nach Anspruch 1 oder 2,
dadurch gekennzeichnet,
daß das Harz nur zwischen die mittleren Einzelbahnen (7') verbracht wird.

4. Verfahren nach einem
der Ansprüche 1 bis 3,
dadurch gekennzeichnet,
daß der Schichtpreßstoff unter Druckeinwirkung abgekühlt wird.

5. Vorrichtung zur Durchführung des Verfahrens nach einem der Ansprüche 1 bis 4,
dadurch gekennzeichnet,
daß eine Doppelbandpresse vorgesehen ist, mit einer Reaktionszone (2), in der die Einzelbahnen (7') verpreßt werden, welche Reaktionszone (2) seitliche Abdichtungen (4) hat, und die Doppelbandpresse eine Vorrichtung (8) zum Aufbringen des Harzes auf die Einzelbahnen aufweist.

6. Vorrichtung nach Anspruch 5,
dadurch gekennzeichnet,
daß vor der Aufbringvorrichtung (8) eine Mühle (12) vorgesehen ist, in der grobkörniges Harz zu Pulver gemahlen wird.

7. Vorrichtung nach Anspruch 5 oder 6,
dadurch gekennzeichnet,
daß eine Vorrichtung zum Verteilen des Harzes auf die Einzelbahnen (7') vorgesehen ist.

8. Vorrichtung nach einem
der Ansprüche 5 bis 7,
dadurch gekennzeichnet,
daß die Reaktionszone (2) eine Vorrichtung (6) zum Kühlen des Schichtpreßstoffes aufweist.
